# EUROPÄISCHE PATENTSCHRIFT

(11) **EP 2 590 489 B1**
(45) Veröffentlichungstag und Bekanntmachung des Hinweises auf die Patenterteilung: **26.10.2022**
(21) Anmeldenummer: 12191019.4
(22) Anmeldetag: 02.11.2012
(51) Int. Cl.: H05K 5/00, H05K 5/06

(54) **Hygienegerechtes Anzeige- und Bediengerät**
Hygienic display and operation device
Appareil de commande et d'affichage hygiénique

(30) Priorität: 07.11.2011 AT 16392011
(43) Veröffentlichungstag der Anmeldung: 08.05.2013
(73) Patentinhaber: B&R Industrial Automation GmbH, 5142 Eggelsberg (AT)
(72) Erfinder: Schwaiger, Rudolf, 83410 Laufen (DE)
(74) Vertreter: Patentanwälte Pinter & Weiss OG

(56) Entgegenhaltungen:
- JP-A- H11 330 730
- US-A- 3 727 926
- US-A- 3 858 752
- US-A1- 2011 169 229

## Beschreibung

Die gegenständliche Erfindung betrifft ein hygienegerechtes Anzeige- und Bediengerät zur Anordnung an Trägerplatte, wobei das Anzeige- und Bediengerät eine Frontplatte und ein Dichtelement aufweist, das im befestigten Zustand des Anzeige- und Bediengeräts an der Trägerplatte zwischen Frontplatte und Trägerplatte angeordnet ist, wobei am Anzeige- und Bediengerät um den Umfang verteilt eine Anzahl von Klemmanordnungen mit jeweils einem Anpresselement vorgesehen sind.

Maschinen und Anlagen für die Chemie-, Lebensmittel- und Pharmaindustrie unterliegen besonders hohen Anforderungen an die Hygiene, speziell bei "offenen" Prozessen, in denen die Erzeugnisse direkt oder indirekt mit dem Fertigungsequipment in Berührung kommen können. Kriterien sind dabei sowohl Korrosionsfestigkeit und eine definierte Oberflächengüte ebenso wie eine geringe Verschmutzungsanfälligkeit und Reinigungsfreundlichkeit. Das bedingt auch ein hohes Maß an Robustheit, denn neben Wasserstrahl und Reinigungsmitteln kommen bei den notwendigen häufigen Reinigungsvorgängen oft auch Hochdruckreiniger zum Einsatz. Dazu sind Standards für die Gerätebeschaffenheit entwickelt worden, um diesen Anforderungen zu genügen, z.B. Schutzart IP69K nach EN 60529. Dabei bedeutet die Ziffer 6 den Schutz der elektrischen Ausrüstung gegen das Eindringen von Festkörpern einschließlich Staub durch völlige Dichtheit und 9K den Schutz gegen das Eindringen von Wasser bei Hochdruck- oder Dampfstrahl-Reinigung.

Während entsprechend ausgeführte Schaltschränke viele Automatisierungskomponenten schützen, sind Anzeige- und Bediengeräte, die oftmals direkt am Arbeitsplatz angeordnet sind, unmittelbar von den Anforderungen dieser Norm betroffen und müssen ebenfalls die definierte Schutzart, z.B. IP69K, aufweisen. Dazu müssen die verwendeten Materialien den Reinigungschemikalien und der Temperatur gewachsen sein, die Abdichtungen müssen zuverlässig, auch unter Druck, das Eindringen von Flüssigkeiten verhindern und auch die Elektronik muss die auftretenden Temperaturwechsel verkraften.

Herkömmliche Dichtungen können diese Anforderungen nicht erfüllen und sind daher ungeeignet, da damit zwischen den abzudichtenden Bauteilen immer ein Spalt verbleibt, in dem sich Bakterien und Keime und andere Verunreinigungen ansiedeln und ablagern können, was für die hohe hygienegerechten Anforderungen unzulässig ist.

Aus der DE 21 37 810 A bzw. der US 3,727,926 wiederum ist eine Abdichtanordnung bekannt, die radial innen zwischen zwei hohlen Bauteilen abdichtet. Dabei ist an einem Bauteil radial innen ein offener Umfangsspalt vorgesehen, in dem ein Dichtelement bündig mit der inneren Umfangsfläche eingesetzt ist. Aus dieser Schrift geht jedoch nicht hervor, wie die Die US 3,858,752 offenbart einen abgedichteten Kunststoff-Behälter, der zwei Hälften aufweist, welche jeweils einen Flansch aufweisen. Zur Versteifung der Flansche können Versteifungselemente angeordnet sein. Zwischen den beiden Flanschen ist eine Dichtung angeordnet und es werden verschiedene wiederverschließbare Klemmvorrichtungen zum Verklemmen der beiden Hälften beschrieben. Es wird jedoch keine Klemmvorrichtung beschrieben, die zur Befestigung eines Anzeige- und Bediengeräts z.B. an einem Schaltschrank geeignet wäre.
beiden Bauteile aneinander gepresst werden, um eine ausreichende Dichtwirkung des Dichtelements zu bewirken.

Die US 3,858,752 offenbart einen abgedichteten Kunststoff-Behälter, der zwei Hälften aufweist, welche jeweils einen Flansch aufweisen. Zur Versteifung der Flansche können Versteifungselemente angeordnet sein. Zwischen den beiden Flanschen ist eine Dichtung angeordnet und es werden verschiedene wiederverschließbare Klemmvorrichtungen zum Verklemmen der beiden Hälften beschrieben. Es wird jedoch keine Klemmvorrichtung beschrieben, die zur Befestigung eines Anzeige- und Bediengeräts z.B. an einem Schaltschrank geeignet wäre.

JP H11 330730 A offenbart ein hygienegerechtes Anzeige- und Bediengerät zur Anordnung an einer Trägerplatte, wobei das Anzeige- und Bediengerät ein speziell geformtes Dichtelement aufweist, das einen Abdeckabschnitt aufweist, der die gesamte frontale Fläche des Anzeige- und Bediengeräts abdeckt und einen Dichtabschnitt aufweist, der zwischen der Frontplatte und der Trägerplatte angeordnet ist.

Die gegenständliche Anmeldung stellt sich daher die Aufgabe, ein hygienegerechtes Anzeige- und Bediengerät bereitzustellen, das möglichst einfach aufgebaut, kostengünstig herstellbar ist und auch auf dünnen Trageelementen möglichst stabil befestigbar ist.

Diese Aufgabe wird erfindungsgemäß dadurch gelöst mit dem hygienegerechten Anzeige- und Bediengerät des Patentanspruchs 1. Bevorzugte Weiterbildungen der Erfindung sind in den Unteransprüchen 2-5 beschrieben. Damit wird sichergestellt, dass am äußeren Umfangsrand der Frontplatte eine bündige Umfangsfläche entsteht, wodurch sich an dieser Stelle kein Spalt ausbilden kann. Mittels des Anpresselements kann das Anzeige- und Bediengerät einfach gegen die Trägerplatte gedrückt und gleichzeitig das Dichtelement zusammengepresst wird, womit eine hygienegerechte Abdichtung hergestellt wird.

Bevorzugt wird das Dichtelement mit einem ersten, am äußeren Umfangsrand angeordneten Dichtkörper ausgeführt, der die äußere Umfangsfläche des Dichtelements bildet. Damit kann mit dem ersten Dichtkörper eine definierte Dichtstelle (Breite, Form, Höhe, etc.) geschaffen werden, die einfach an die jeweiligen Bedürfnisse optimal angepasst werden kann, ohne notwendigerweise den Rest des Dichtelements ändern zu müssen.

Wenn innerhalb des ersten Dichtkörpers ein weiterer Dichtkörper vorgesehen ist, wird die Sicherheit der Abdichtung erhöht, vor allem, um bei einer Hochdruckreinigung sicherzustellen, dass kein Reinigungsmedium eindringen kann, falls die äußere Dichtbarriere überwunden werden würde.

Ebenso ist es vorteilhaft, wenn der erste Dichtkörper und /oder der weitere Dichtkörper eine größere Höhe aufweist als die Tiefe der Umfangsnut, da auch damit die Wirkung der Abdichtung gezielt angepasst werden kann. Insbesondere kann damit der Anpressdruck und damit die Dichtwirkung gezielt eingestellt werden.

Um die Montage zu erleichtern, kann am Grund der Umfangsnut eine Anzahl von Vertiefungen angeordnet sein, in die am Dichtelement angeordnete Vorsprünge eingreifen. Damit kann das Dichtelement am Anzeige- und Bediengerät einfach lagefixiert werden.

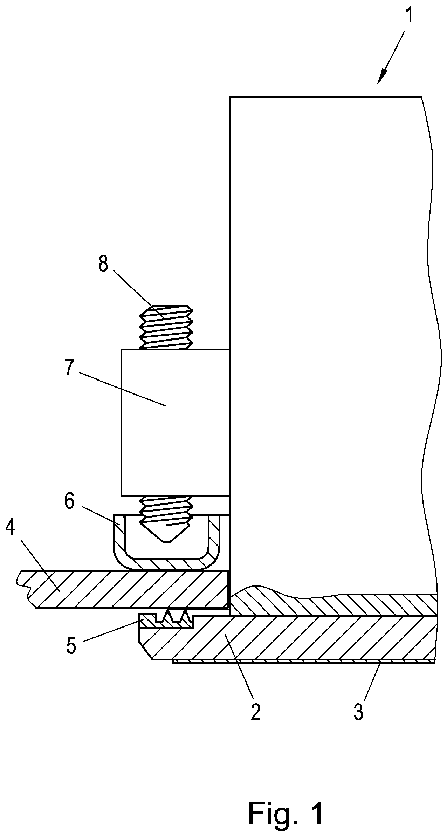

Nachfolgend wird die gegenständliche Erfindung unter Bezugnahme auf die Figuren 1 bis 3, die beispielhaft, schematisch und nicht einschränkend vorteilhafte Ausgestaltungen der Erfindung zeigen beschrieben.

Fig. 1 zeigt ein Anzeige- und Bediengerät 1 mit einer nach außen sichtbaren Frontplatte 2, z.B. aus Edelstahl. Die Frontplatte 2 kann hier nicht näher dargestellte Anzeigeeinheiten, wie z.B. Displays, Lampen, Touchpanels, etc., und Bedieneinheiten, wie z.B. Knöpfe, Tasten, Touchpanel, etc., aufweisen. Die Anzeige- und Bedieneinheiten können nach außen zum Schutz und aus Hygienegründen durch eine geeignete Folie 3 abgedeckt sein, wie in Fig. 1 dargestellt. Das Anzeige- und Bediengerät 1 kann an einer Trägerplatte 4 angeordnet werden. Die Trägerplatte 4 könnte z.B. Teil eines Maschinengehäuses oder Schaltschrankgehäuses oder jedes anderen beliebigen Maschinen- oder Anlagenteils sein.

Im dargestellten Ausführungsbeispiel kann das Anzeige- und Bediengerät 1 durch einen Halterahmen 6 an der Trägerplatte 4 gehalten werden. Der Halterahmen 6 ist dabei vorteilhaft um den Umfang des Anzeige- und Bediengeräts 1 herum angeordnet. Am Anzeige- und Bediengerät 1 sind um den Umfang verteilt eine Anzahl von Klemmeinheiten 7 angeordnet, in denen jeweils eine Anpressschraube 8 durchgeschraubt ist. Die Anpressschrauben 8 greifen mit einem axialen Ende am Halterahmen 6 an. Der Halterahmen 6 kann nun mittels der Anpressschrauben 8 gegen die Trägerplatte 4 gedrückt werden, womit das Anzeige- und Bediengerät 1 ebenfalls gegen die Trägerplatte 4 gedrückt wird. Dadurch wird das Dichtelement 5 zusammengepresst, womit eine hygienegerechte Abdichtung hergestellt wird, wie nachfolgend im Detail beschrieben ist. Selbstverständlich könnte man auch auf den Halterrahmen 6 verzichten, insbesondere bei einer ausreichend dicken Trägerplatte 4, womit in diesem Fall die Anpressschrauben direkt an der Trägerplatte 4 angreifen würden.

Ebenso sind auch beliebige andere Klemmanordnungen zum Halten des Anzeige- und Bediengeräts 1 denkbar, wie z.B. an sich bekannte Spannhebel oder federbetätigte Spanner. Anstelle einer Anpressschraube 8 als Anpresselement kommt in diesem Fall ein anderes Anpresselement, das an der Trägerplatte 4 oder an einem Halterahmen 6 angreift, zum Einsatz.

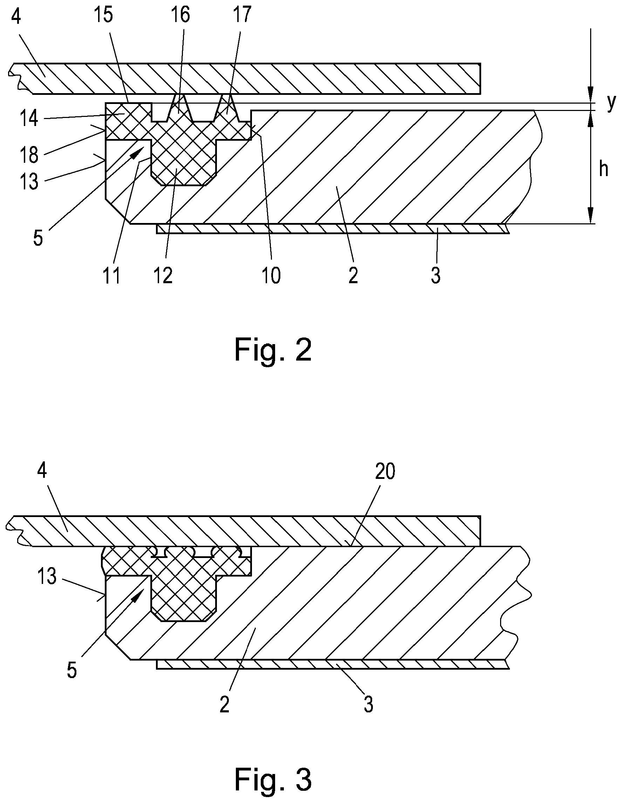

Um einen Spalt zwischen Frontplatte 2 und Trägerplatte 4 zu eliminieren, ist zwischen diesen Teilen ein erfindungsgemäßes Dichtelement 5 vorgesehen, das unter Bezugnahme auf die Fig.2 und 3 näher beschrieben wird.

An der Frontplatte 2 ist am äußeren Umfang eine umlaufende Umfangsnut 10 vorgesehen, die an der äußeren Umfangsfläche 13 der Frontplatte 2 offen ist und in der das Dichtelement 5 eingesetzt ist. Das Dichtelement 5 ist dabei am äußeren Umfangsrand bündig mit der äußeren Umfangsfläche 13 der Frontplatte 2 angeordnet, sodass sich im zusammengepressten Zustand (Fig.3) eine durchgehende Umfangsfläche ohne Spalt ergibt.

Das Dichtelement 5 ist dazu als nahtloser Rahmen ausgeführt, das in der Umfangsnut 10 angeordnet wird, wobei die äußere Umfangsfläche 18 des Dichtelements 5 bündig mit der Umfangsfläche 13 der Frontplatte 2 angeordnet ist. Am äußeren Umfangsrand des Dichtelements 5 ist ein erster Dichtkörper 14 vorgesehen, der am äußeren Umfangsrand bündig mit der Umfangsfläche 13 der Trägerplatte 4 abschließt. Der erste Dichtkörper 14 ist hier rechteckförmig ausgestaltet mit einer ebenen, der Trägerplatte 4 zugewandten Dichtfläche 15, die parallel zur flächenmäßigen Erstreckung der Trägerplatte 4 und der Frontplatte 2 angeordnet ist.

Wenn das Dichtelement 5 in der Umfangsnut 10 eingesetzt ist, ist der erste Dichtkörper 14 im nicht zusammengebauten Zustand (Fig. 2) bevorzugt um ein Maß y höher als die Höhe h der Frontplatte 2 - oder anders ausgedrückt ist die Höhe des ersten Dichtkörpers 14 um ein Maß y höher als die Tiefe der Umfangsnut 10. Damit wird sichergestellt, dass der erste Dichtkörper 14 beim Zusammenbau zusammengedrückt wird.

Innerhalb des außen angeordneten ersten Dichtkörpers 14 können optional noch weitere, weiter innen angeordnete Dichtkörper, z.B. zweite und dritte dreieckförmige Dichtkörper 16, 17 wie im dargestellten Ausführungsbeispiel, angeordnet sein. Auch diese können eine größere Höhe aufweisen als die Tiefe der Umfangsnut 10, um ein Zusammendrücken der Dichtkörper 16,17 bei Zusammenbau sicherzustellen. Diese weiteren Dichtkörper 16, 17 dienen vorrangig als zusätzliche Sicherheit, um vor allem bei einer Hochdruckreinigung sicherzustellen, dass kein Reinigungsmedium eindringen kann.

Es kann auch vorgesehen sein, dass am Grund der Umfangsnut 10 über den Umfang verteilt eine Anzahl von Vertiefungen 11, z.B. Sackbohrungen, angeordnet sind, in denen am Dichtelement angeordnete Vorsprünge 12, wie z.B. vorspringende Noppen, eingreifen, um das Dichtelement 5 in der Lage zu fixieren, was die Montage erleichtern kann.

Das Dichtelement 5 ist ein nahtloser Rahmen, z.B. aus Silikon, oder einem anderen geeigneten Kunststoff, der bevorzugt in einem Teil auf exaktes Maß spritzgegossen wird. Endlosprofile, die in die Umfangsnut 10 eingesetzt werden sind für die gegenständliche Anwendung im Hygienebereich nicht geeignet, das sich an der stirnseitigen Stoßstelle immer ein Spalt ergibt.

Beim Zusammenbau (Fig. 3) werden die Trägerplatte 4 und die Frontplatte 2 soweit zusammengepresst, bis die beiden Platten an einer Berührfläche 20 flach aneinander liegen. Dabei wird das Dichtelement 5, bzw. die Dichtkörper 14, 16, 17, in der Höhe zusammengedrückt, um eine ausreichende Dichtwirkung zu erzielen. An der äußeren Umfangsfläche 13 ergibt sich ein nahtloser und spaltloser Übergang zwischen Frontplatte 2 und Trägerplatte 4, um den hohen Anforderungen im Hygienebereich gerecht zu werden. Die Dichtkörper 14, 16, 17 werden sich dabei ausbauchen (wie in Fig. 3 übertrieben dargestellt), wobei die äußere Umfangsflächen 13, 18 der Frontplatte 2 und des Dichtelements 5 trotz Ausbauchung immer noch als bündig angesehen werden. Wesentlich ist hierbei, dass an der äußeren Umfangsfläche zwischen Frontplatte 2 und Trägerplatte 4 kein Spalt entsteht.

## Patentansprüche

1. Hygienegerechtes Anzeige- und Bediengerät (1) zur Anordnung an einer Trägerplatte (4), wobei das Anzeige- und Bediengerät (1) eine Frontplatte (2) und ein Dichtelement (5) aufweist, das im zusammengepressten Zustand des Anzeige- und Bediengeräts (1) an der Trägerplatte (4) zwischen der Frontplatte (2) und der Trägerplatte (4) angeordnet ist, wobei am Anzeige- und Bediengerät (1) um den Umfang verteilt eine Anzahl von Klemmanordnungen mit jeweils einem Anpresselement (8) vorgesehen sind, wobei jedes Anpresselement (8) mit einem axialen Ende an einem an der Trägerplatte (4) anliegenden Halterahmen (6) oder an der Trägerplatte (4) angreift, wobei am äußeren Rand der Frontplatte (2) eine Umfangsnut (10) vorgesehen ist, die an der äußeren Umfangsfläche (13) der Frontplatte (2) offen ist, wobei das Dichtelement (5) in der Umfangsnut (10) eingesetzt ist, **dadurch gekennzeichnet, dass** die äußere Umfangsfläche (18) des Dichtelements (5) bündig mit der äußeren Umfangsfläche (13) der Frontplatte (2) angeordnet ist

2. Hygienegerechtes Anzeige- und Bediengerät nach Anspruch 1, **dadurch gekennzeichnet, dass** am Dichtelement (5) am äußeren Umfangsrand ein erster Dichtkörper (14) vorgesehen ist, der die äußere Umfangsfläche (18) des Dichtelements (5) bildet.

3. Hygienegerechtes Anzeige- und Bediengerät nach Anspruch 2, **dadurch gekennzeichnet, dass** innerhalb des ersten Dichtkörpers (14) ein weiterer Dichtkörper (16, 17) vorgesehen ist.

4. Hygienegerechtes Anzeige- und Bediengerät nach Anspruch 2 oder 3, **dadurch gekennzeichnet, dass** der erste Dichtkörper (14) und /oder der weitere Dichtkörper (16, 17) eine größere Höhe aufweist als die Tiefe der Umfangsnut (10).

5. Hygienegerechtes Anzeige- und Bediengerät nach einem der Ansprüche 1 bis 4, **dadurch gekennzeichnet, dass** am Grund der Umfangsnut (10) eine Anzahl von Vertiefungen (11) angeordnet sind, in die am Dichtelement (5) angeordnete Vorsprünge (12) eingreifen.

## Claims

1. A hygiene-compliant display and control device (1) for arrangement on a mounting plate (4), wherein the display and control device (1) comprises a front plate (2) and a sealing element (5), which sealing element (5) is arranged between the front plate (2) and the mounting plate (4) in a compressed state of the display and control device (1) on the mounting plate (4), wherein a number of clamping arrangements, each having a pressing element (8), are provided on the display and control device (1) distributed around the periphery, wherein each pressing element (8) engages with an axial end with a fixing frame (6), which abuts the mounting plate (4), or with the mounting plate (4), wherein a peripheral groove (10) is provided on the outer edge of the front plate (2), which groove is open on the outer peripheral surface (13) of the front plate (2), wherein the sealing element (5) is fitted in the peripheral groove (10), **characterized in that** the outer peripheral surface (18) of the sealing element (5) is arranged flush with the outer peripheral surface (13) of the front plate (2).

2. The hygiene-compliant display and control device as claimed in claim 1, **characterized in that** a first sealing body (14) is provided at the outer peripheral edge of the sealing element (5), which sealing body (14) forms the outer peripheral surface (18) of the sealing element (5).

3. The hygiene-compliant display and control device as claimed in claim 2, **characterized in that** a further sealing body (16, 17) is provided inside the first sealing body (14).

4. The hygiene-compliant display and control device as claimed in claim 2 or 3, **characterized in that** the first sealing body (14) and/or the further sealing body (16, 17) has a greater height than the depth of the peripheral groove (10).

5. The hygiene-compliant display and control device as claimed in one of claims 1 to 4, **characterized in that** a number of depressions (11) are arranged at the base of the peripheral groove (10), in which depressions (11) projections (12) arranged on the sealing element (5) engage.

## Revendications

1. Appareil d'affichage et de commande (1) hygiénique destiné à être monté sur une plaque de support (4), l'appareil d'affichage et de commande (1) présentant une plaque frontale (2) et un élément d'étanchéité (5), lequel, à l'état comprimé de l'appareil d'affichage et de commande (1), est disposé sur la plaque de support (4) entre la plaque frontale (2) et la plaque de support (4), un certain nombre d'agencements de serrage comportant respectivement un élément de pression (8) étant prévus répartis sur la circonférence sur l'appareil d'affichage et de commande (1), chaque élément de pression (8) venant en prise par une extrémité axiale avec un cadre de retenue (6) reposant sur la plaque de support (4) ou avec la plaque de support (4), une rainure circonférentielle (10) étant prévue sur le bord extérieur de la plaque frontale (2) et étant ouverte sur la surface circonférentielle extérieure (13) de la plaque frontale (2), l'élément d'étanchéité (5) étant inséré dans la rainure circonférentielle (10), **caractérisé en ce que** la surface circonférentielle extérieure (18) de l'élément d'étanchéité (5) est disposée en affleurement avec la surface circonférentielle extérieure (13) de la plaque frontale (2).

2. Appareil d'affichage et de commande hygiénique selon la revendication 1, **caractérisé en ce qu'**un premier corps d'étanchéité (14) formant la surface circonférentielle extérieure (18) de l'élément d'étanchéité (5) est prévu sur l'élément d'étanchéité (5) sur le bord circonférentiel extérieur.

3. Appareil d'affichage et de commande hygiénique selon la revendication 2, **caractérisé en ce qu'**un autre corps d'étanchéité (16, 17) est prévu à l'intérieur du premier corps d'étanchéité (14).

4. Appareil d'affichage et de commande hygiénique selon la revendication 2 ou 3, **caractérisé en ce que** le premier corps d'étanchéité (14) et/ou l'autre corps d'étanchéité (16, 17) présentent une hauteur supérieure à la profondeur de la rainure circonférentielle (10).

5. Appareil d'affichage et de commande hygiénique selon l'une des revendications 1 à 4, **caractérisé en ce qu'**un certain nombre de cavités (11), dans lesquelles des saillies (12) disposées sur l'élément d'étanchéité (5) viennent en prise, sont disposées sur le fond de la rainure circonférentielle (10).
